# EUROPEAN PATENT APPLICATION

(11) **EP 2 667 693 A2**
(43) Date of publication of application: **27.11.2013**
(21) Application number: 12192490.6
(22) Date of filing: 14.11.2012
(51) Int. Cl.: H05K 7/14

(54) **Electronic component mounting module and power conversion apparatus**

(30) Priority: 21.05.2012 JP 2012115952
(71) Applicant: Kabushiki Kaisha Yaskawa Denki, Kitakyushu-Shi Fukuoka 806 (JP)
(72) Inventor: Yamanaka, Yasunori, Kitakyushu-shi, Fukuoka 806-0004 (JP)
(74) Representative: Grünecker, Kinkeldey, Stockmair & Schwanhäusser

(57) **Abstract**

An electronic component mounting module (2) according to an embodiment includes a mounting member (21), a pressing member (22), and a fastening member (23) . The mounting member (21) includes a component housing frame (201) that houses an electronic component (41, 42) generating heat during operation so as to be in contact with at least a part of a side face thereof, and that holds the electronic component (41, 42) so as to expose a main heat radiating surface thereof toward a heat sink (11). The pressing member (22) is mounted on the mounting member (21), and presses the mounting member (21) and the electronic component (41, 42) at the same time toward the heat sink (11) through a heat sink layer (13). The fastening member (23) presses the pressing member (22) toward the heat sink (11), and thus presses to fix the component housing frame (201) and the electronic component (41, 42) to the heat sink layer (13).

## Description

### FIELD

The embodiment discussed herein is directed to an electronic component mounting module and a power conversion apparatus.

### BACKGROUND

Conventionally, when an electronic component, such as a power semiconductor device, generating relatively intense heat during operation is mounted on equipment, the electronic component is tightly attached to a heat sink with an insulating sheet interposed therebetween so as to release the heat.

An example of a mounting device for mounting the electronic component so as to be tightly attached to the heat sink is a device provided with mounting screws for screwing the electronic component to the heat sink and with a metal holddown part having holes for inserting the mounting screws therethrough.

As a document about the above-described conventional technology, there is, for example, Japanese Patent Application Laid-open No. H11-317586.

However, the conventional mounting device still leaves room for improvement in insulating property between the electronic component having a predetermined electric potential and the heat sink having generally a ground potential. The insulating sheet or the like is certainly interposed between the electronic component and the heat sink. However, the mounting screws are screwed into the heat sink, and thus are made to have the same electric potential as that of the heat sink. Thus, it cannot be said that sufficient consideration is taken for the insulation between the mounting screws and the electronic component.

For example, a power conversion apparatus or the like may be installed outdoors or the like where the installation environment is severe. Therefore, the insulation performance is considered to be degraded by occurrence of condensation or by invasion of dust, dirt, and the like, thus increasing a likelihood of earth faults or short circuits.

It is an object of an aspect of the embodiment to provide an electronic component mounting module and a power conversion apparatus that excel in insulating property.

### SUMMARY

An electronic component mounting module according to an aspect of an embodiment includes: a mounting member including a component housing frame that houses an electronic component generating heat during operation so as to be in contact with at least a part of a side face thereof, and that holds the electronic component so as to expose a main heat radiating surface thereof toward a heat sink; a pressing member that is mounted on the mounting member and presses the mounting member and the electronic component at the same time toward the heat sink through a heat sink layer; and a fastening member that presses the pressing member toward the heat sink and thus presses to fix the component housing frame and the electronic component to the heat sink layer.

According to the aspect of the embodiment, it is possible to provide an electronic component mounting module that ensures an insulation distance between an electronic component and a heat sink, and thus has good insulating property.

### BRIEF DESCRIPTION OF DRAWINGS

A more complete appreciation of the invention and many of the attendant advantages thereof will be readily obtained as the same becomes better understood by reference to the following detailed description when considered in connection with the accompanying drawings.

FIG. 1 is an exploded perspective view of a power conversion apparatus according to an embodiment of the present invention;

FIG. 2 is an explanatory diagram schematically illustrating a circuit of the power conversion apparatus;

FIG. 3 is an exploded perspective view illustrating a mounting structure of an electronic component mounting module according to the present embodiment;

FIG. 4 is a perspective view illustrating a mounting member of the electronic component mounting module;

FIG. 5 is a perspective view illustrating a pressing member of the electronic component mounting module;

FIG. 6 is an explanatory diagram illustrated by way of a sectional view of the electronic component mounting module;

FIG. 7 is a functional explanatory diagram of the electronic component mounting module; and

FIGS. 8A, 8B, and 8C are explanatory diagrams each illustrating an example of a layout of electronic components.

### DESCRIPTION OF EMBODIMENT

An embodiment of an electronic component mounting module and a power conversion apparatus disclosed herein will be described below in detail with reference to the accompanying drawings. Note that the present invention is not limited to the embodiment illustrated below.

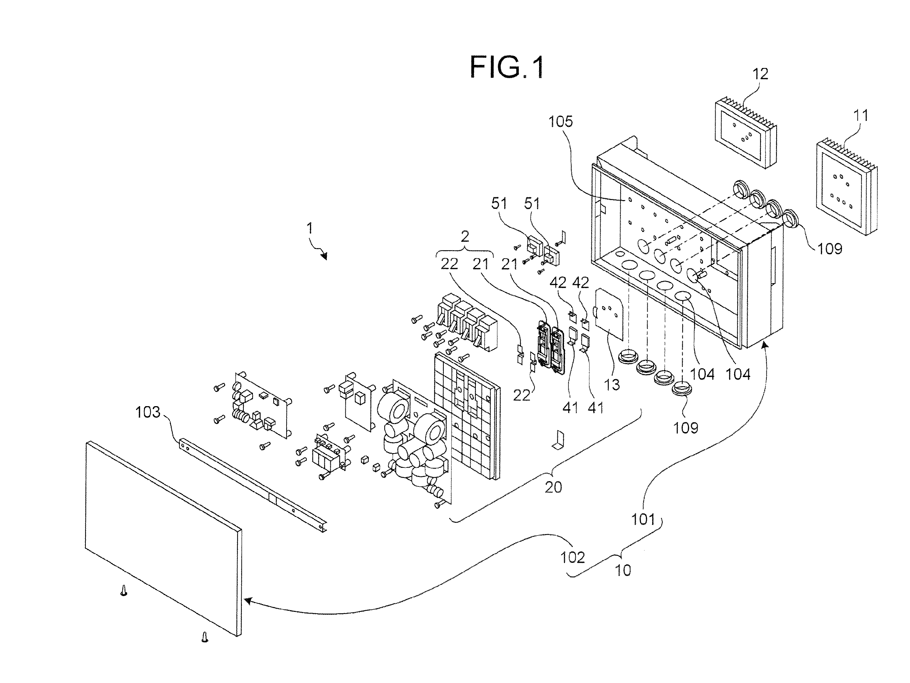

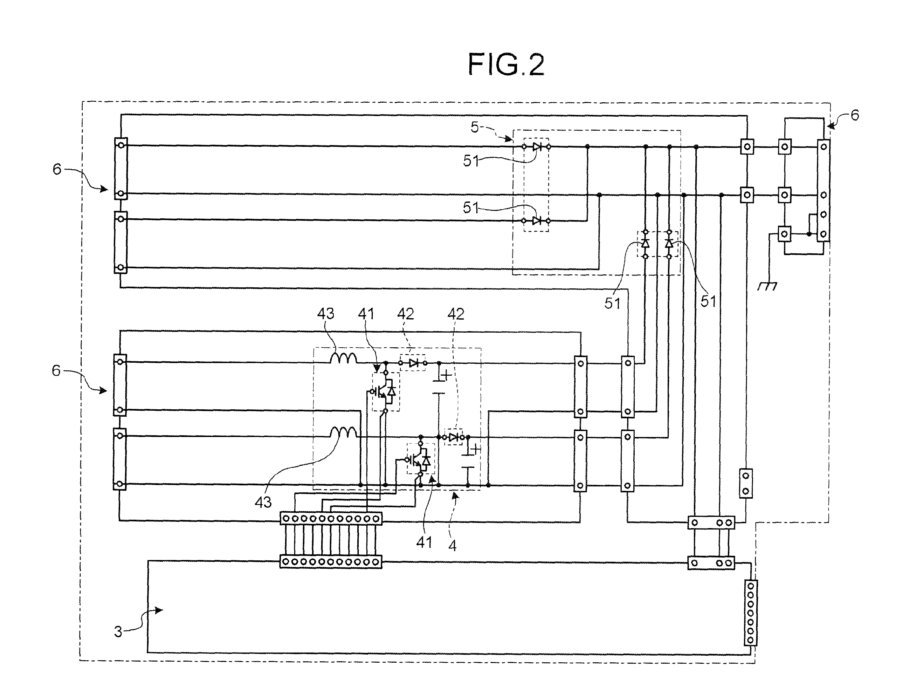

First, this power conversion apparatus 1 according to the present embodiment will be described using FIGS. 1 and 2. FIG. 1 is an exploded perspective view of the power conversion apparatus 1, and FIG. 2 is an explanatory diagram schematically illustrating a circuit of the power conversion apparatus 1.

The power conversion apparatus 1 according to the present embodiment will be described below as a unit having a voltage boost function to adjust a direct-current voltage supplied from a power generation device, such as a photovoltaic solar cell panel, to a predetermined voltage. The direct-current power boosted by the power conversion apparatus 1 is supplied, for example, to a power conditioner and converted into alternating-current power that can be used at home and the like.

The power conversion apparatus 1 is provided, as illustrated in FIG. 1, with a power converter 20 in a housing 10 having a substantially rectangular shape. The power converter 20 is provided, as illustrated in FIG. 2, with a control circuit 3 provided on a control board, a voltage boost circuit 4 provided on a power board, a backflow prevention circuit 5 provided on a diode board, and a terminal unit 6 provided with terminal blocks for external connection. Although the terminal unit 6 is illustrated in a separated manner for convenience of explaining a configuration of the circuit, the terminal unit 6 may be arranged wholly in the same position or may be arranged separately in different positions in a structure of an actual apparatus.

The voltage boost circuit 4 functions as a voltage booster that boosts the voltage of a direct-current power supply, and is provided with a power module 41 including a switching element serving as a semiconductor device for power conversion. An insulated gate bipolar transistor (IGBT) is used as the switching element provided in the power module 41. The power module 41 is provided, on the input side thereof, with a direct-current reactor 43 for voltage boosting, and provided, on the output side thereof, with a voltage boosting diode 42.

The housing 10 of the power conversion apparatus 1 according to the present embodiment includes, as illustrated in FIG. 1, a box-shaped case 101 and a faceplate 102 mounted at the front opening of the case 101. Note that reference numeral 103 represents a bar-like holding member supporting the power converter 20, reference numeral 104 represents cable insertion holes, and reference numeral 109 represents bushes for protecting cables.

A first heat sink 11 and a second heat sink 12 are provided so as to be isolated right and left from each other on a back face 105 of the housing 10. Both of the first and the second heat sinks 11 and 12 are made of metal, such as aluminum, having a good thermal conductivity, and are formed all over with a plurality of fins in order to further increase heat radiation performance. Note that, in the description below, the heat sink may be referred to simply as the heat sink 11 or the heat sink 12 without making a distinction between the first and the second.

In the power conversion apparatus 1 according to the present embodiment, electronic components such as the power module 41 having the switching element and the voltage boosting diode 42 are mounted on the heat sink 11 to release heat.

For that purpose, the power conversion apparatus 1 according to the present embodiment is provided with an electronic component mounting module 2 (hereinafter simply called "mounting module 2") that is mountable to the heat sink 11 while holding the electronic components (such as the power module 41 and the voltage boosting diode 42) in a state of maintaining a high insulation performance.

The mounting module 2 has a configuration capable of pressing to fix the electronic components, in the state of housing them, to the first heat sink 11 with a heat sink layer 13 interposed therebetween. The power conversion apparatus 1 according to the present embodiment is characterized by being provided with the thus configured mounting module 2.

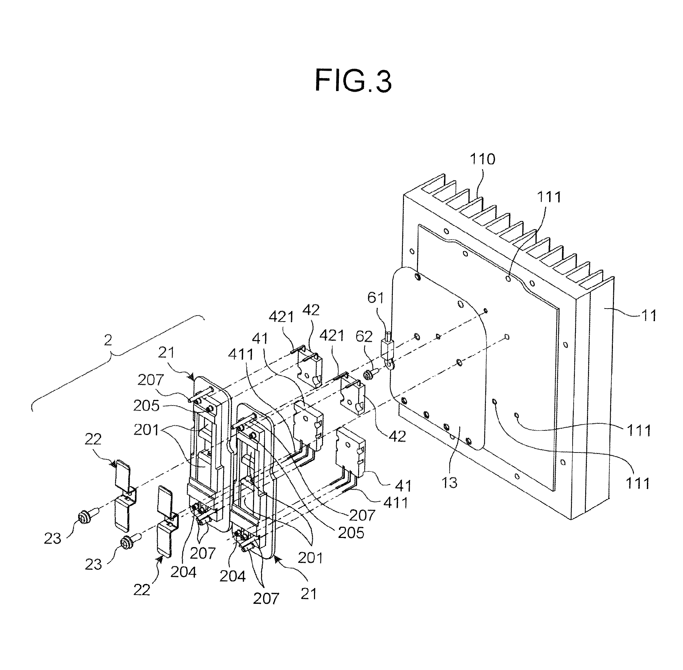

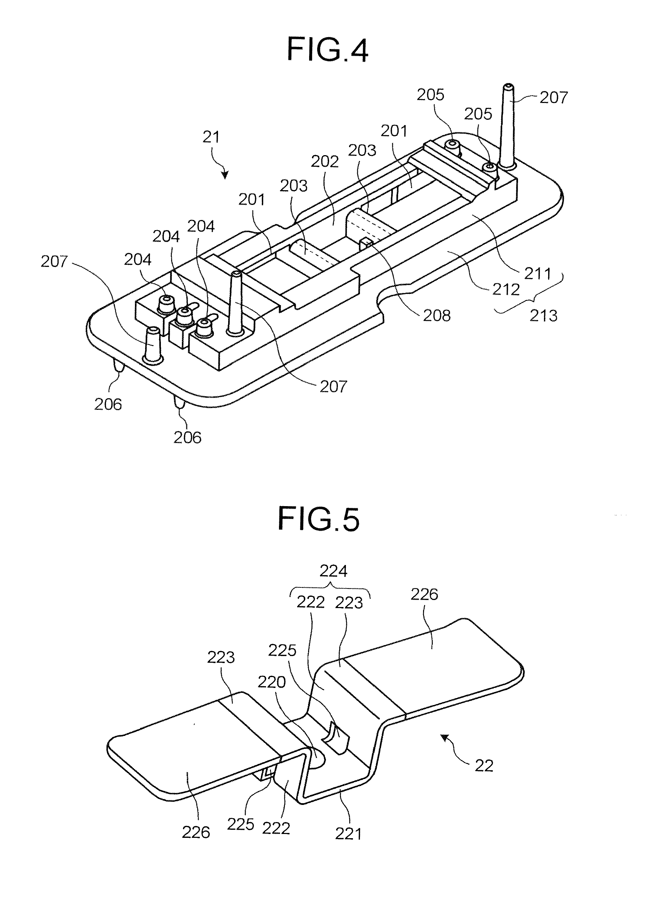

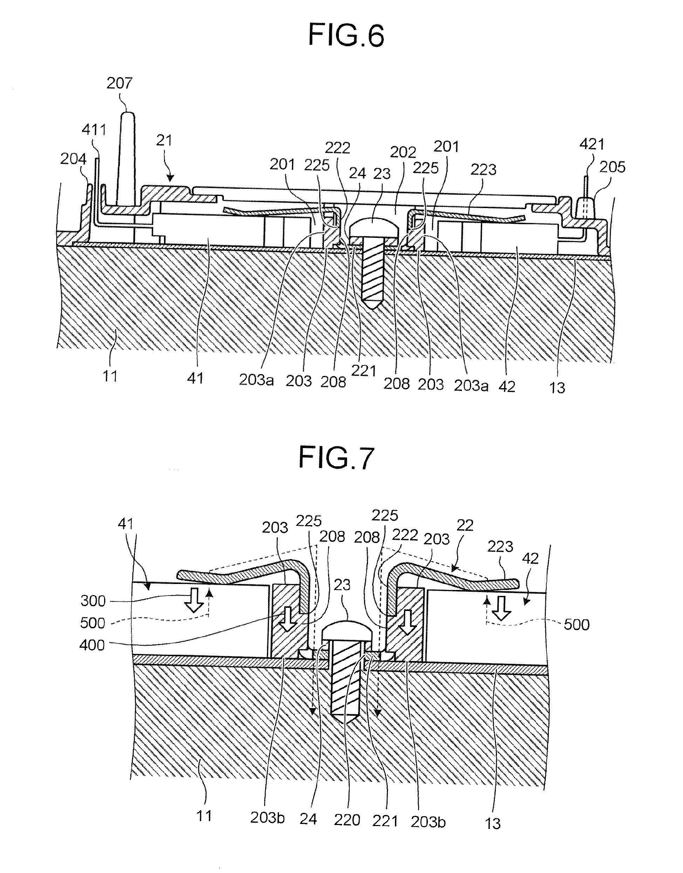

The mounting module 2 will be described below in detail with reference to FIGS. 3 to 7. FIG. 3 is an exploded perspective view illustrating a mounting structure of the mounting module 2, and FIG. 4 is a perspective view illustrating a mounting member 21 of the mounting module 2. FIG. 5 is a perspective view illustrating a pressing member 22 of the mounting module 2; FIG. 6 is an explanatory diagram illustrated by way of a sectional view of the mounting module 2; and FIG. 7 is a functional explanatory diagram of the mounting module 2.

As illustrated in FIG. 3, the mounting module 2 is provided with the mounting member 21, the pressing member 22, and a screw 23 serving as a fastening member.
As illustrated therein, a thermistor 61 is also mounted, with a mounting screw 62, on the first heat sink 11 in the present embodiment.

The mounting member 21 has a component housing frame 201 that houses the electronic component generating heat during operation, such as the power module 41, so as to be in contact with at least a part of a side face thereof, and that holds the electronic component so as to expose a main heat radiating surface thereof toward the first heat sink 11. The pressing member 22 is fitted to the mounting member 21, and presses the mounting member 21 and, at the same time, the power module 41 and the voltage boosting diode 42 that are the electronic components housed in the mounting member 21, toward the first heat sink 11 through the heat sink layer 13. The screw 23 presses the pressing member 22 toward the first heat sink 11, and thus can press to fix the component housing frame 201 and the electronic component (the power module 41 or the voltage boosting diode 42) to the heat sink layer 13. The screw 23 is screwed in with a spring washer 24 or the like interposed thereunder, as illustrated in FIGS. 6 and 7.

The heat sink layer 13 includes a heat radiation sheet having an insulating property and compound (or grease or the like), and, as illustrated in FIG. 3, is attached to the first heat sink 11. In other words, the mounting member 21 presses to fix the main heat radiating surfaces of the electronic components such as the power module 41 and the voltage boosting diode 42 to the heat sink 11 with the heat sink layer 13 having an insulating property interposed between the main heat radiating surfaces and the first heat sink 11, and thus allows the electronic components to release heat.

Here, the mounting member 21 will be described more specifically using FIGS. 3 and 4. As illustrated therein, the mounting member 21 includes a frame-like body 213 including a frame body 211 having a substantially rectangular shape and a flange 212 extending outward from the frame body 211.

The frame body 211 is provided, in a substantially central position thereof, with a press-fixing portion housing frame 202 that houses a press-fixing portion 221 of the pressing member 22 to be described later in detail. In addition, insulation walls 203 are provided on both sides of the press-fixing portion housing frame 202, and the component housing frame 201 is provided so as to face an outer side face 203a of each of the insulation walls 203 (refer to FIG. 6).Herein, the press-fixing portion housing frame 202 corresponds to a fixing portion housing frame in claims. The press-fixing portion 221 corresponds to a fixing portion in claims.

In other words, the component housing frames 201, 201 and the press-fixing portion housing frame 202 are partitioned by wall bodies provided in the frame body 211. At least a part of side faces of each of the electronic components (the power module 41 and the voltage boosting diode 42) comes in contact with at least a part of the thus provided wall bodies, and thus, the electronic components are housed in a positioned state.

The wall bodies constituting the component housing frames 201, 201 and the press-fixing portion housing frame 202 partially serve as the insulation wall 203. Accordingly, when the screw 23 is screwed in, the component housing frames 201, 201 are pressed toward the heat sink 11, and leading edge surfaces 203b of the insulation walls 203 are pressed to be fixed to the heat sink layer 13 (refer to FIG. 7). In other words, each of the insulation walls 203 according to the present embodiment is formed by the wall body interposed between the electronic component and the screw 23 inserted in the heat sink 11, and, when the screw 23 is screwed in, the leading edge surface 203b of the insulation wall 203 is tightly attached to the heat sink layer 13 in a secure manner.

The insulation wall 203 is provided with a projection 208 projecting toward the press-fixing portion housing frame 202. The projection 208 is configured to engage with a recess 225 formed in the pressing member 22 to be described later in detail. Providing the thus formed projection 208 allows the pressing member 22 to press the insulation wall 203 toward the heat sink 11 when the screw 23 is screwed in, as will be described later.

The mounting member 21 is provided with guides 204 and 205 as illustrated in FIGS. 3, 4, and 6. The guides 204 and 205 guide leads 411 and 421 extending from the electronic components (the power module 41 and the voltage boosting diode 42) toward the board (not illustrated) provided with the power conversion circuitry of the power converter 20 (refer to FIG. 2).

Each set of the guides 204 and the guides 205 are provided in cylindrically projecting shapes at constant intervals on the frame body 211. Three of the guides 204 are provided corresponding to the three leads 411 of the power module 41. On the other hand, two of the guides 205 are provided corresponding to the two leads 421 of each of the voltage boosting diodes 42.

Providing the guides 204 and 205 such as described above suppresses a problem from occurring when connecting the multiple leads 411 and 421 extending from the power module 41 and the voltage boosting diode 42 to predetermined terminals provided on the board to be connected thereto even if respective spaces between the leads 411 and 421 are slightly uneven. In other words, the respective spaces between the leads can be forcibly aligned to have a uniform distance by inserting the leads 411 and 421 in the guides 204 and 205, respectively.

In addition, each of the power module 41 and the voltage boosting diode 42 is housed in a positioned state in the component housing frame 201 of the mounting member 21. The connection to the predetermined terminals provided on the board can be performed in an easy and reliable manner.

As illustrated in FIG. 3, the heat sink 11 has a plurality of positioning holes 111. In addition, as illustrated in FIG. 4, the flange 212 of the mounting member 2 is provided with positioning projections 206 corresponding to the positioning holes 111 of the heat sink 11. Three of the positioning holes 111 and three of the positioning projections 206 are provided for one of the mounting members 21. Two of the positioning projections 206 are provided near an end on one side of the mounting member 21 (refer to FIG. 4) while one of the positioning projections 206, although not illustrated, is provided near an end on the other side thereof.

As illustrated in FIG. 4, the mounting member 21 is also provided with positioning projections 207 corresponding to positioning holes (not illustrated) formed in the board. The positioning projections 207 in the present embodiment are provided, one near the guides 204 on the frame body 211 and one each at both ends of the flange 212.

In this manner, the electronic components can be housed by using the mounting member 21, and, in addition, the mounting member 21 is provided with the positioning structure that can mount the electronic components to the board and the heat sink 11 at respective predetermined attitudes. Moreover, the mounting member 21 has the guides 204 and 205 that correctly guide the leads 411 and 421 of the power module 41 and the voltage boosting diode 42 toward the board to be connected thereto. Therefore, it is possible to easily perform an operation of connecting the electronic components mounted on the heat sink 11 to the predetermined terminals provided on the board.

Next, the pressing member 22 of the mounting module 2 will be specifically described using FIGS. 3 and 5. The pressing member 22 is formed by bending a strip-like metal sheet, and, as illustrated, is provided with the press-fixing portion 221 having an insertion hole 220 for inserting the screw 23 serving as a fastening member, and with substantially L-shaped elastic portions 224 connected to ends of the press-fixing portion 221.

Each of the elastic portions 224 has a standing portion 222 that stands from the end of the press-fixing portion 221 and has the recess 225 engaging with the projection 208 provided on the insulation wall 203 of the mounting member 21, and also has an extending portion 223 with an end thereof extending outward from the standing portion 222.

If the back face of the electronic component (the power module 41 or the voltage boosting diode 42) serves as the main heat radiating surface, the extending portion 223 of the elastic portion 224 is configured so as to urge the electronic component toward the heat sink 11 by coming in contact with the belly surface (opposite surface to the main heat radiating surface) of the electronic component. For that purpose, the extending portion 223 extends over the insulation wall 203 constituting a part of the wall bodies, and, after extending at a slightly downslope gradient, comes in contact with the belly of the electronic component.

In this manner, in each of the elastic portions 224, the extending portion 223 extending from the standing portion 222 acts like a leaf spring, and thus, the elastic portions 224 can urge the electronic components toward the heat sink 11, as indicated by arrows 300 in FIG. 7. In the pressing member 22, the elastic portions 224 such as described above are integrally connected to both ends of the press-fixing portion 221. In other words, as illustrated in FIG. 5, the elastic portions 224 are formed like wings from the both sides (for example, the right and the left) of the press-fixing portion 221.

Therefore, the single pressing member 22 can simultaneously press the two electronic components housed in the component housing frames 201, 201 of the mounting member 21 together with the mounting member 21 toward the heat sink 11. Note that the extending portions 223 directly coming in contact with the electronic components as described above are coated with insulating material 226 made of synthetic resin or the like.

In this manner, the pressing member 22 presses the electronic components (the power module 41 and the voltage boosting diode 42) with the elastic portions 224. A specific pressing structure for pressing the mounting member 21 is configured as described below.

As illustrated in FIG. 5, each of the standing portions 222 has the recess 225 engaging with the projection 208 provided on the insulation wall 203. Specifically, the recess 225 as a hole having a substantially rectangular shape is formed so as to extend across a boundary between the press-fixing portion 221 and the standing portion 222.

Accordingly, by inserting the press-fixing portion 221 of the pressing member 22 into the press-fixing portion housing frame 202 of the mounting member 21, and then by screwing in the screw 23 while the recess 225 is in the engaged state with the projection 208 provided on the insulation wall 203, the mounting member 21 is strongly pressed toward the heat sink 11.

In other words, as indicated by arrows 400 in FIG. 7, the mounting member 21 is strongly pressed toward the heat sink 11 through the projection 208, and thus, the leading edge surfaces 203b of the insulation walls 203 are tightly attached to the heat sink layer 13.

In conclusion, the respective internal spaces of the component housing frames 201, 201 housing the electronic components are partitioned in a reliable manner from each other and from the internal space of the press-fixing portion housing frame 202 in which the screw 32 is positioned, the screw 32 having the same electric potential as that of the heat sink 11 by being screwed into the heat sink 11. Thus, the insulating property is improved.

In this manner, the insulation walls 203 are present between the respective component housing frames 201, 201 and the press-fixing portion housing frame 202, and thereby, a necessary insulation distance can be provided between each of the electronic components and the heat sink 11 (screw 23).

As described above, the pressing member 22 is made of metal, and is coated with the insulating material 226 only at the extending portions 223. Therefore, in the mounting module 2 according to the present embodiment, the height of the insulation walls 203 is specified as follows.

That is, the height of the insulation walls 203 is specified to be a height enough for ensuring a predetermined insulation distance between the standing portion 222 that is not coated with the insulating material 226 and each of the electronic components (the power module 41 and the voltage boosting diode 42). Consequently, the insulating property of the mounting module 2 can be further improved.

As has been described above, the power conversion apparatus 1 according to the present embodiment connects the electronic components (the power module 41 and the voltage boosting diode 42) to the predetermined terminals provided on the board to be connected thereto while placing the electronic components in contact with the heat sink 11 by using the electronic component mounting module 2 provided with the mounting member 21, the pressing member 22, and the screw 23.

The mounting member 21 has the component housing frames 201, 201 that house the electronic components (the power module 41 and the voltage boosting diode 42) generating heat during operation so as to be in contact with at least a part of the side faces thereof, and that hold the electronic components so as to expose the main heat radiating surfaces thereof toward the heat sink 11. The pressing member 22 is configured to be fitted to the mounting member 21 and to press the mounting member 21 and the electronic components at the same time toward the heat sink 11 through the heat sink layer 13. The screw 23 presses the pressing member 22 toward the heat sink 11, and thus can press to fix the component housing frames 201, 201 and the electronic components to the heat sink layer 13.

With such a configuration, even if condensation occurs, or dust, dirt, and the like enter the power conversion apparatus 1 when the apparatus is installed at a place such as outdoors where the installation environment is severe, it is possible to suppress the insulation performance from degrading and to prevent earth faults and short circuits as much as possible.

With the above-described configuration, as illustrated in FIG. 7, each of the electronic components is pressed, at the belly surface (that is, the opposite surface to the main heat radiating surface) thereof, by the extending portion 223 of the pressing member 22. Accordingly, the heat of the electronic components is released, as indicated by arrows 500 in FIG. 7, not only from the main heat radiating surfaces but also from the belly surfaces, and thus, the heat radiation performance is also improved. In other words, the heat of the electronic components is released by being transmitted from the main heat radiating surfaces toward the heat sink 11 directly through the heat sink layer 13, and also by being transmitted from the belly surfaces, via the extending portions 223, the standing portions 222, the press-fixing portion 221, and the heat sink layer 13, to the heat sink 11.

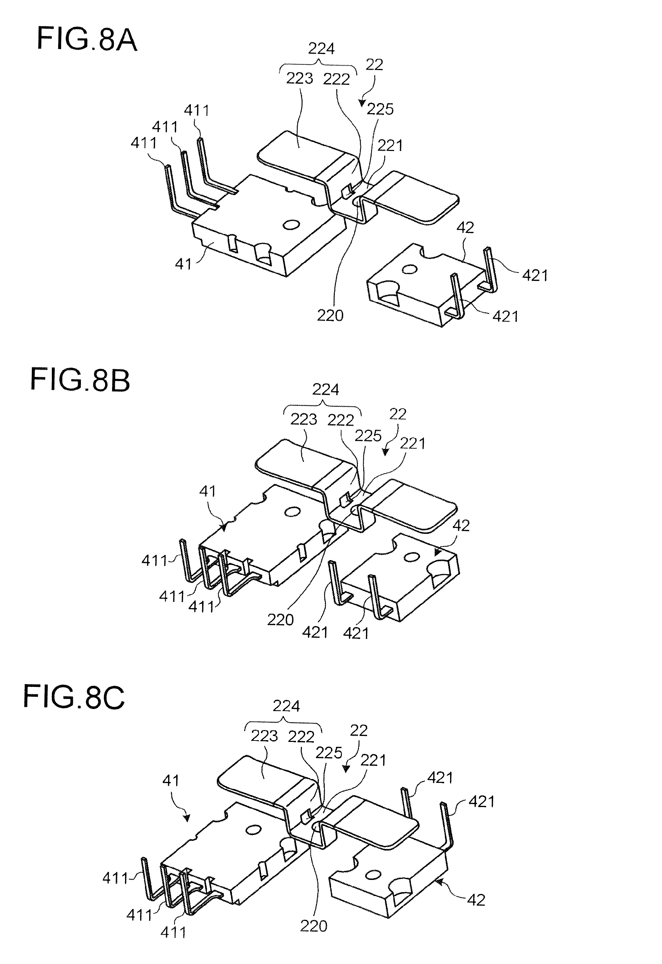

FIGS, 8A to 8C are explanatory diagrams each illustrating an example of a layout of the electronic components. In the electronic component mounting module 2 according to the present embodiment, the electronic components (the power module 41 and the voltage boosting diode 42) are arranged, as illustrated in FIG. 8A, so that the extending directions of the leads 411 and 421 are directed in the extending directions of the extending portions 223 of the pressing member 22.

However, the layout of the power module 41 and the voltage boosting diode 42 is not limited to the layout according to the present embodiment. For example, as illustrated in FIGS. 8B and 8C, the extending directions of the leads 411 and 421 may be arranged to be directed in directions perpendicular to the extending directions of the extending portions 223 of the pressing member 22.

In that case, as a matter of course, it is recommended to change the shape of the mounting member 21 and also to appropriately change the layout of the guides 204 and 205 that correctly guide the leads 411 and 421 toward the board to be connected thereto.

The electronic component mounting module 2 according to the present embodiment that has been described above is configured to be capable of mounting two electronic components (the power module 41 and the voltage boosting diode 42 in the present embodiment) at the same time. In other words, the mounting member 21 is provided with the two component housing frames 201, 201, and the pressing member 22 is provided with the two elastic portions 224. However, the electronic component mounting module 2 can be configured to be capable of mounting three or more electronic components.

The electronic component mounting module 2 may also be configured not to be capable of mounting a plurality of electronic components but to be capable of mounting a single electronic component (such as the power module 41 or the voltage boosting diode 42). In other words, the mounting member 21 may be configured to be provided with one component housing frame 201, and the pressing member 22 may be configured to be provided with one elastic portion 224.

Although the description has been made by exemplifying the power module 41 and the voltage boosting diode 42 as the electronic components, the electronic components may be any components that generate heat during operation.

Other semiconductor devices than the insulated gate bipolar transistor (IGBT) can be used as the switching element constituting the power module 41.

While the power conversion apparatus 1 includes the two circuits that boost the direct-current voltage and the two circuits that use the direct-current voltage that is not boosted in the present embodiment (refer to FIG. 2), the power conversion apparatus is not limited to have this composition. The power conversion apparatus may include, for example, only one circuit that boosts the direct-current voltage.

## Claims

1. An electronic component mounting module (2) comprising:
a mounting member (21) including a component housing frame (201) that houses an electronic component (41, 42) generating heat during operation so as to be in contact with at least a part of a side face thereof, and that holds the electronic component (41, 42) so as to expose a main heat radiating surface thereof toward a heat sink (11);
a pressing member (22) that is mounted on the mounting member (21) and presses the mounting member (21) and the electronic component (41, 42) at the same time toward the heat sink (11) through a heat sink layer (13); and
a fastening member (23) that presses the pressing member (22) toward the heat sink (11) and thus presses to fix the component housing frame (201) and the electronic component (41, 42) to the heat sink layer (13).

2. The electronic component mounting module (2) according to claim 1, wherein the mounting member (21) includes a wall body that constitutes the component housing frame (201) and is interposed between the electronic component (41, 42) and the fastening member (23) inserted in the heat sink (11), at least a part of the wall body serving as an insulation, wall (203) tightly attached to the heat sink layer (13).

3. The electronic component mounting module (2) according to claim 1 or 2, wherein the mounting member (21) comprises a guide (204, 205) that guides a lead (411, 421) extending from the electronic component (41, 42) toward a board to be connected thereto.

4. The electronic component mounting module (2) according to claim 3, wherein the mounting member (21) comprises a positioning projection (207) corresponding to a positioning hole formed in the board.

5. The electronic component mounting module (2) according to any one of claims 1 to 4, wherein the mounting member (21) comprises a positioning projection (206) corresponding to a positioning hole (111) formed in the heat sink (11).

6. The electronic component mounting module (2) according to any one of claims 2 to 5, wherein
the pressing member (22) comprises:
a fixing portion (221) having an insertion hole (220) in which the fastening member (23) is inserted; and
an elastic portion (224) connected to an end of the fixing portion (221); wherein
the elastic portion (224) comprises:
a standing portion (222) that stands from the end of the fixing portion (221) and has a recess (225) engaging with a projection (208) provided on the insulation wall (203) of the mounting member (21); and
an extending portion (223) with an end thereof extending outward from the standing portion (222) over the wall body to come in contact with the electronic component (41, 42) so as to urge the electronic component (41, 42) toward the heat sink (11).

7. The electronic component mounting module (2) according to claim 6, wherein the extending portion (223) is coated with insulating material (226).

8. The electronic component mounting module (2) according to claim 6 or 7, wherein the insulation wall (203) has a height that ensures a predetermined insulation distance between the electronic component (41, 42) and the standing portion (222) of the pressing member (22).

9. The electronic component mounting module (2) according to any one of claims 6 to 8, wherein the mounting member (21) is provided, in a substantially central position thereof, with a fixing portion housing frame (202) that houses the fixing portion (221) of the pressing member (22), and is provided with the insulation wall (203) on each side of the fixing portion housing frame (202) and with the component housing frame (201) that faces an outer side face of the insulation wall (203).

10. The electronic component mounting module (2) according to any one of claims 6 to 9, wherein the elastic portion (224) of the pressing member (22) is integrally connected to each of both ends of the fixing portion (221).

11. A power conversion apparatus (1) comprising:
a power converter (20) that includes a semiconductor device serving as an electronic component and is used for converting power between a predetermined power generation device and a commercial electric power system; and
the electronic component mounting module (2) according to any one of claims 1 to 10.
